# EUROPÄISCHE PATENTSCHRIFT

(11) **EP 0 762 592 B1**
(45) Veröffentlichungstag und Bekanntmachung des Hinweises auf die Patenterteilung: **11.08.1999**
(21) Anmeldenummer: 96108369.8
(22) Anmeldetag: 25.05.1996
(51) Int. Cl.: H02J 7/00, H02J 7/10

(54) **Akkumulator und Verfahren zur Erkennung des Akkumulatortyps**
Battery and method for recognising the battery type
Batterie et méthode pour reconnaître le type de batterie

(30) Priorität: 31.08.1995 DE 19532013
(43) Veröffentlichungstag der Anmeldung: 12.03.1997
(73) Patentinhaber: MOTOROLA, INC., Schaumburg, IL 60196 (US)
(72) Erfinder: Lorenz, Bernd, Dipl. Ing., 13469 Berlin (DE); Gens, Michael, Dipl.-Ing., 13503 Berlin (DE)
(74) Vertreter: Richardt, Markus Albert

(56) Entgegenhaltungen:
- GB-A- 2 270 983
- US-A- 5 200 686
- US-A- 5 371 453
- MOTOROLA TECHNICAL DEVELOPMENTS, Bd. 20, 1.Oktober 1993, Seite 26 XP000403804 PATINO J ET AL: "TWO CONTACT BATTERY SCHEME THAT ALLOWS CAPACITY AND THERMISTOR IDENTIFICATION"
- IBM TECHNICAL DISCLOSURE BULLETIN, Bd. 35, Nr. 3, 1.August 1992, Seiten 420-421, XP000326327 "EXPANDED BATTERY TYPE RECOGNITION METHOD"

## Beschreibung

### Stand der Technik

Die Erfindung geht von einem Akkumulator nach der Gattung des Oberbegriffes des Hauptanspruchs aus, wie er in GB 2 270 983 beschrieben ist.

Aus der EP 0 500 545 B1 ist ferner ein Akkumulator bekannt, bei dem ein Temperatursensor in thermischer Kopplung mit dem Energiespeicher verbunden ist. Der Temperatursensor erfaßt die Temperatur des Energiespeichers, so daß nach Erreichen einer Grenztemperatur das Ladegerät abgeschaltet und der Energiespeicher vor Schäden wie Überladung bewahrt wird. Vom Akkumulator zum Ladegerät führen daher drei Leitungen. Daher ist zum Aufladen des Energiespeichers mindestens eine dritte Leitung erforderlich, die auf einen entsprechenden Kontrolleingang des Ladegeräts führt.

Aus der DE 36 37 669 C2 ist ein Akkumulator, der eine seinen Kennwerten entsprechende Codierung aufweist und ein Ladegerät mit einer Decodiervorrichtung zum Erkennen der Codierung des Akkumulators und zum Umschalten der Ladeschaltung des Ladegeräts auf die elektrischen Kennwerte des aufzuladenden Akkumulators bekannt. Die Codierung erfolgt dabei durch eine am Gehäuseäußeren angebrachte Markierung oder durch einen entsprechenden, im Gehäuse des Akkumulators untergebrachten Kennungswiderstand, der jedoch zwei zusätzliche Anschlüsse erfordert.

### Vorteile der Erfindung

Der erfindungsgemäße Akkumulator mit den Merkmalen des Hauptanspruchs hat demgegenüber den Vorteil, daß der bereits für die Temperaturüberwachung vorgesehene dritte Anschluß des Akkumulators auch zur Erkennung des Akkumulatortyps verwendet wird und somit keine weiteren Anschlüsse notwendig sind. Als weiterer Vorteil ist anzusehen, daß die zur Erkennung des Akkumulatortyps vorsehbare Diodenschaltung im Akkumulator untergebracht ist, so daß die Erkennung weitgehend von äußeren Einflüssen wie z.B. Verschmutzung und Beschädigung unabhängig ist. Durch die in den Unteransprüchen aufgeführten Maßnahmen sind vorteilhafte Verfahren zur Erkennung des im Hauptanspruch angegebenen Akkumulators möglich. Besonders vorteilhaft ist, daß die Erkennung des Akkumulatortyps durch einen von einer Gleichspannungsquelle hervorgerufenen Spannungsabfall zwischen zwei Anschlüssen des Akkumulators wenig Aufwand erfordert und daß dieser Spannungsabfall weiterhin in einfacher Weise dazu benutzt werden kann, den Ladestrom des Ladegeräts direkt zu steuern.

### Zeichnungen

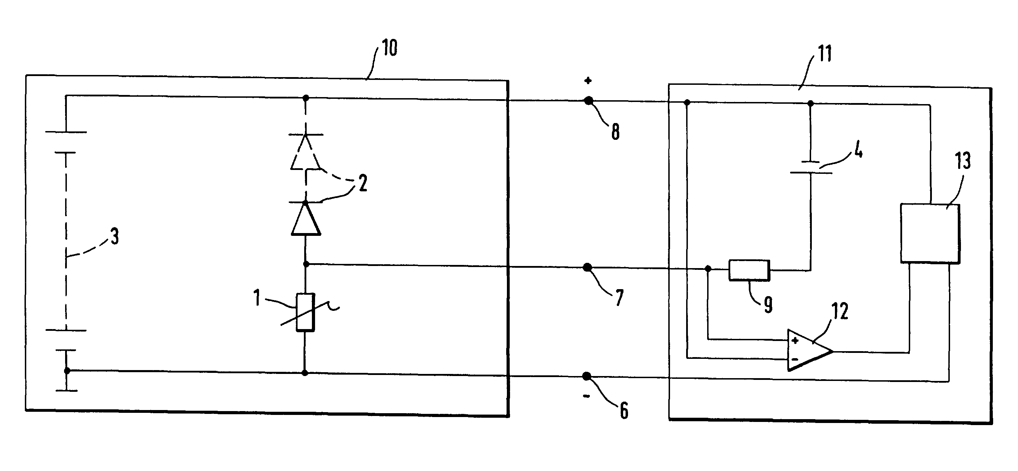

Ein Ausführungsbeispiel der Erfindung ist in der Zeichnung dargestellt und in der nachfolgenden Beschreibung näher erläutert. Die Figur zeigt einen Akkumulator mit einem Ladegerät.

### Beschreibung des Ausführungsbeispiels

In der Figur bezeichnen 10 einen Akkumulator mit einem Energiespeicher 3, der mit einem ersten und einem zweiten Anschluß 6 und 8 des Akkumulators 10 zur Ladung und Spannungsentnahme verbunden ist und 11 ein Ladegerät. Zum Schutz des Energiespeichers 3 gegen zu starke Erwärmung, die während des Aufladevorgangs mit hohem Strom eintreten kann, wird ein Temperatursensor 1 derart am Energiespeicher 3 befestigt, daß er mit ihm in thermischer Kopplung steht. Der Temperatursensor 1 mißt nun die Temperatur des Energiespeichers 3 während des Ladevorgangs und gibt ein temperaturabhängiges Signal über einen dritten Anschluß 7 an das Ladegerät 11 ab. Über diesen Anschluß 7 wird in Abhängigkeit von der Temperatur des Energiespeichers 3 der Ladestrom für den Energiespeicher 3 geregelt. Erreicht die Temperatur einen bestimmten Wert, dann wird davon ausgegangen, daß nunmehr der Energiespeicher 3 geladen ist. Das Signal des Temperatursensors 1 wird dann zum Abschalten des Ladegeräts 11 verwendet.

Zwischen dem zweiten Anschluß 8 und dem dritten Anschluß 7 sind eine oder mehrere in Reihe geschaltete Dioden 2 gleicher Polaritätsrichtung so gepolt vorhanden, daß keine Entladung des Energiespeichers 3 über den Temperatursensor 1 erfolgen kann. Dazu sind der zweite Anschluß 8 als Pluspol des Akkumulators 10 an die Kathode der mit dem Energiespeicher 3 verbundenen Diode 2 und der dritte Anschluß 7 an die Anode der mit dem Temperatursensor 1 verbundenen Diode 2 angeschlossen. Die Zahl der Dioden dient hierbei zur Kennzeichnung z.B. der Kapazität oder Nennspannung des Akkumulators. Im Ladegerät 11 ist eine Gleichspannungsquelle 4 mit einem vorschaltbaren Widerstand 9 zur Strombegrenzung an den zweiten und dritten Anschluß 8 und 7 in Flußrichtung der Dioden angeschlossen. Die Spannungen an den Anschlüssen 7 und 8 werden auf den nicht invertierenden und den invertierenden Eingang eines Differenzverstärkers 12 geführt. Am Ausgang des Differenzverstärkers liegt eine gesteuerte Stromquelle 13, die den Ladestrom liefert und zu diesem Zweck mit den Anschlüssen 6 und 8 des Akkumulators verbunden ist.

Der durch die Dioden 2 bewirkte Spannungsabfall zwischen dem zweiten und dem dritten Anschluß 8 und 7 hängt von der Anzahl der Dioden 2 ab, und ist daher charakteristisch für den verwendeten Akkumulatortyp. Der Spannungsabfall wird dem Differenzverstärker 12 zugeführt und von diesem verstärkt. Die verstärkte Spannung regelt über die gesteuerte Stromquelle 13 den für den erkannten Akkumulatortyp notwendigen Ladestrom.

Eine Erkennungsmöglichkeit ist auch dann gegeben, wenn die Zahl der Dioden zwischen dem zweiten Anschluß 8 und dem dritten Anschluß 7 Null ist, so daß im Akkumulator 10 keine Verbindung zwischen diesen beiden Anschlüssen besteht. Der durch die Gleichspannungsquelle 4 bewirkte Spannungsabfall zwischen dem zweiten und dem dritten Anschluß 8 und 7 entspricht dann der Gleichspannung der Gleichspannungsquelle 4 und ist daher ebenfalls für den verwendeten Akkumulatortyp charakteristisch.

## Patentansprüche

1. Akkumulator (10) mit einem Energiespeicher (3), der mit einem ersten und einem zweiten Anschluß (6, 8) des Akkumulators (10) zur Ladung und Spannungsentnahme verbunden ist und mit einem Temperatursensor (1), der mit dem Energiespeicher in Wirkverbindung steht, und mit einem dritten Anschluß (7) mit welchem eine Reihe von Dioden (2) mit gleicher Polaritätsrichtung anschließbar sind,
dadurch gekennzeichnet, daß der Temperatursensor (1) einerseits mit dem ersten Anschluß (6) und andererseits mit dem dritten Anschluß (7) des Akkumulators (10) verbunden ist, daß zwischen dem dritten Anschluß (7) und dem zweiten Anschluß (8) entweder Keine Verbindung im Akkumulator (10) besteht oder eine oder mehrere in Reihe geschaltete Dioden (2) angeordnet sind, bei welchen die Polaritätsrichtung so bestimmt ist, daß keine Entladung des Energiespeichers über den Temperatursensor (1) erfolgt.

2. Verfahren zur Erkennung eines Akkumulators (10) nach Anspruch 1, dadurch gekennzeichnet, daß an den zweiten Anschluß (8) und den dritten Anschluß (7) eine Gleichspannungsquelle (4) in Flußrichtung der Dioden angeschlossen wird, daß der durch die Gleichspannung bewirkte Spannungsabfall zwischen dem zweiten und dem dritten Anschluß (8, 7) gemessen wird und daß aufgrund des Spannungsabfalls der Akkumulator (10) erkannt wird.

3. Verfahren nach Anspruch 2, dadurch gekennzeichnet, daß der Ladestrom eines Ladegerätes auf den erkannten Akkumulatortyp eingestellt wird.

4. Verfahren nach Anspruch 2 oder 3, dadurch gekennzeichnet, daß der Strom der Spannungsquelle (4) vorzugsweise durch einen Widerstand (9) begrenzt wird.

## Revendications

1. Accumulateur (10) comprenant un accumulateur d'énergie (3) relié à un premier et un deuxième raccordements (6, 8) de l'accumulateur (10) pour le chargement et le soutirage de tension, et comprenant un capteur de température (1) en relation efficace avec l'accumulateur d'énergie, et comprenant un troisième raccordement (7), auquel on peut connecter une série de diodes (2) d'un même sens de polarité, caractérisé en ce que le capteur de température (1) est relié d'une part au premier raccordement (6) et d'autre part au troisième raccordement (7) de l'accumulateur (10), et en ce qu'entre le troisième raccordement (7) et le deuxième raccordement (8) soit il n'existe pas de liaison avec l'accumulateur (10), soit une ou plusieurs diodes (2) sont disposées en série, leur sens de polarité étant défini pour assurer qu'aucun déchargement de l'accumulateur d'énergie ne puisse se produire par l'intermédiaire du capteur de température (1).

2. Procédé d'identification d'un accumulateur (10) selon la revendication 1, caractérisé en ce qu'une source de tension continue (4) est connectée au deuxième raccordement (8) et au troisième raccordement (7) dans le sens du flux des diodes, en ce que la baisse de tension provoquée par la tension continue entre le deuxième et le troisième raccordements (8, 7) est mesurée, et en ce que l'accumulateur (10) est identifié en raison de la baisse de tension.

3. Procédé selon la revendication 2, caractérisé en ce que le courant de charge d'un chargeur est réglé sur le type d'accumulateur identifié.

4. Procédé selon la revendication 2 ou 3, caractérisé en ce que le courant de la source de tension (4) est de préférence limité par une résistance (9).

## Claims

1. Battery (10) with an energy storage unit (3) which is connected to a first and second connection (6, 8) of the battery (10) for the purposes of charging and also of supplying power and with a temperature sensor (1) which is in a functional connection with the energy storage unit and with a third connection (7), with which a row of diodes (2) which all have the same polarity can be connected, characterised by the fact that the temperature sensor (1) which is between the third connection (7) and the second connection (8) either has no connection to the battery (10) or one or more diodes are placed in a row where the polarity setting is so arranged that no discharging over the temperature sensor (1) can take place.

2. A method of recognising a battery (10) according to Claim 1 characterised by the fact that a DC voltage source (4) is connected to the second connection (8) and the third connection (7) in the direction of flow of the diodes, that the voltage gradient induced by the DC voltage between the second and the third connections (8,7) is measured and that the type of battery (10) is established based upon this voltage gradient.

3. A method according to Claim 2 characterised by the fact that the charging current from a battery charger is set for the type of battery to be charged.

4. A method according to Claim 2 or 3 characterised by the fact that the preferred design is that where the current from the voltage source (4) is limited by a resistance (9).
